(19) Europäisches Patentamt
European Patent Office
Office européen des brevets

(11) **EP 3 772 655 A1**

(12) **EUROPEAN PATENT APPLICATION**

(43) Date of publication:
**10.02.2021 Bulletin 2021/06**

(51) Int Cl.:
***G01R 15/24*** *(2006.01)*

(21) Application number: **19190753.4**

(22) Date of filing: **08.08.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ABB Schweiz AG**
**5400 Baden (CH)**

(72) Inventor: **BOHNERT, Klaus**
**5452 Oberrohrdorf (CH)**

(74) Representative: **Vossius & Partner**
**Patentanwälte Rechtsanwälte mbB**
**Siebertstrasse 3**
**81675 München (DE)**

(54) **FIBER-OPTICAL VOLTAGE SENSOR**

(57) The present invention relates to a fiber-optic sensor for measuring an optical phase shift $\phi$ between two orthogonal polarization modes of a polarization-maintaining optical sensing fiber (300), comprising an integrated-optic waveguide beam splitter (IOW) having a first port at a first side and N second ports at a second side, the first and second side being preferably opposite to each other, N being a positive integer $N \geq 2$, and the integrated-optic waveguide beam splitter (IOW) having a splitter plane; M polarizing elements (PE1...PEM), M being a positive integer $M \geq 2$, coupled to the second side of the integrated-optic waveguide beam splitter (IOW); a birefringent optical element (R) arranged between at least one of the M polarizing elements (PE1...PEM) and at least one port of the N ports of the second side of the 1 x N integrated-optic waveguide beam splitter (IOW); a polarization-maintaining optical sensing fiber (300) having slow and fast principal axes and having a first end coupled to the first port of the integrated-optic waveguide beam splitter (IOW) and a second end connected to a reflector, wherein at least one of the M polarizing elements is configured to receive a light signal from a light source, such that the light signal is sent through one of the second ports to the polarization-maintaining optical sensing fiber (300), wherein the M polarizing elements (PE1...PEM) have polarization directions of 45° ($\pm$15°) or -45° ($\pm$15°) with respect to the slow axis of the polarization-maintaining optical sensing fiber (300), wherein a principal axis of the birefringent optical element (R) is oriented at 0° ($\pm$15°) with respect to the slow axis of the polarization-maintaining optical sensing fiber (300), wherein the birefringent optical element (R) is configured to introduce a birefringent phase delay in a range of (2m -1) x 90° ($\pm$15°), where m is a positive integer.

Figure 4

**Description**

FIELD OF THE INVENTION

The invention relates to a fiber-optical voltage sensor for an electric power transmission system.

BACKGROUND OF THE INVENTION

Optical electric field and voltage sensors commonly make use of an electro-optic effect (Pockels effect) in an electro-optic crystal such as BGO ($Bi_4Ge_3O_{12}$). The sensors, which are configured to where the full power line voltage (up to several 100 kV) is applied along the longitudinal axis of a cylinder-shaped crystal. The crystal length may be in a range between 100 and 300 mm.

In order to prevent dielectric breakdown due to the high electric field strengths in the crystal's vicinity, adequate electric insulation measures are required. For example, the sensor may reside in a hollow-core insulator filled with pressurized Sulfur hexafluoride ($SF_6$) gas or in a solid-state insulator comprising a body of resin-impregnated paper or resin-impregnated fiber with embedded cylinder-shaped metal foils for field steering. Another design concept derives the voltage from three local electro-optic field sensors arranged along the axis of a nitrogen gas filled hollow insulator column. The insulator incorporates measures to shield the sensors from the fields of adjacent electric phases.

The above insulation methods have one thing in common that they are expensive and result in a large transformer size similar to the size of conventional inductive or capacitive voltage transformers.

In addition, a voltage sensor may also measure the voltage by integrating the electric field between ground and high voltage by a series of piezo-electric quartz crystals. An optical fiber senses the piezo-electric deformations of the crystals. This kind of voltage sensor may employ an interrogation technique related to white light interferometry. Furthermore, an alternative interrogation technique based on non-reciprocal phase modulation as used in fiber-optic gyroscopes and current sensors may be adopted. However, a drawback of both interrogation techniques is that a polarization-maintaining fiber between the sensor head and the interrogator (opto-electronics module) is required.

DESCRIPTION OF THE INVENTION

These and other objectives are achieved by a voltage sensing structure according to the independent claims. Preferred embodiments are evident from the dependent patent claims.

The present invention relates to a fiber-optic sensor for measuring an optical phase shift $\phi$ between two orthogonal polarization modes of a polarization-maintaining optical sensing fiber, comprising an integrated-optic waveguide beam splitter having a first port at a first side and N second ports at a second side, the first and second side being preferably opposite to each other, N being a positive integer N $\geq$ 2, and the integrated-optic waveguide beam splitter having a splitter plane; M polarizing elements, M being a positive integer M $\geq$ 2, coupled to the second side of the integrated-optic waveguide beam splitter; a birefringent optical element arranged between at least one of the M polarizing elements and at least one port of the N ports of the second side of the 1 x N integrated-optic waveguide beam splitter; a polarization-maintaining optical sensing fiber having slow and fast principal axes and having a first end coupled to the first port of the integrated-optic waveguide beam splitter and a second end connected to a reflector, wherein at least one of the M polarizing elements is configured to receive a light signal from a light source, such that the light signal is sent through one of the second ports to the polarization-maintaining optical sensing fiber, wherein the M polarizing elements have polarization directions of 45° ($\pm$15°) or -45° ($\pm$15°) with respect to the slow axis of the polarization-maintaining optical sensing fiber, wherein a principal axis of the birefringent optical element is oriented at 0° ($\pm$15°) with respect to the slow axis of the polarization-maintaining optical sensing fiber, wherein the birefringent optical element is configured to introduce a birefringent phase delay in a range of (2m -1) $\times$ 90° ($\pm$15°), where m is a positive integer.

Preferably, the light source is a broadband light source.

Preferably, the birefringent optical element is arranged between the at least one of the M polarizing elements and at least one port of the N ports of the second side connected being different from the at least one of the M polarizing elements which is configured to receive the light signal from the light source.

The present invention also relates to a fiber-optic sensor for measuring an optical phase shift $\phi$ between two orthogonal polarization modes of a polarization-maintaining optical sensing fiber, the fiber-optic sensor comprising an integrated-optic waveguide beam splitter having a first port at a first side and N second ports at a second side, the first and second side being preferably opposite to each other, N being a positive integer N $\geq$ 2, and the integrated-optic waveguide beam splitter having a splitter plane; M polarizing elements, M being a positive integer M $\geq$ 2, coupled to the second side of the integrated-optic waveguide beam splitter; a birefringent optical element arranged between at least one of the M polarizing elements and at least one port of the N ports of the second side of the 1 x N integrated-optic waveguide beam splitter; a polarization-maintaining optical sensing fiber having slow and fast principal axes and having a first end coupled to the first port of the integrated-optic waveguide beam splitter and a second end connected to a another polarizing element which is connected to a light source, wherein the M polarizing elements have polarization directions of 45° ($\pm$15°) or - 45° ($\pm$15°) with respect to the slow axis of the polarization-maintaining optical sensing fiber, wherein a principal axis of the birefringent optical element is oriented at 0° ($\pm$15°) with respect to the slow axis of the polarization-maintaining optical sensing fiber, and wherein the birefringent optical element is configured to introduce a birefringent phase delay in a range of (2m -1) $\times$ 90° ($\pm$15°), where m is a positive integer, and wherein the another polarizing element has a polarization direction of 45° ($\pm$15°) with respect to a principal axis of the polarization-maintaining optical sensing fiber.

Preferably, the light source is a broadband light source.

Preferably, the slow axis of the polarization-maintaining optical sensing fiber is oriented at 0° ($\pm$15°) or 90° ($\pm$15°) with respect to the normal of the splitter plane.

Preferably, the polarization-maintaining optical sensing fiber comprises a first section and a second section.

Preferably, the first and second fiber sections are coupled to each other such that the slow principal axis of the first section is orthogonal to the slow principal axis of the second section.

Preferably, the birefringent optical element is provided in a recess of the integrated-optic waveguide beam splitter.

Preferably, first end of the polarization-maintaining optical sensing fiber is coupled to the first port of the integrated-optic waveguide beam splitter by a first polarization-maintaining fiber lead and a second polarization-maintaining fiber lead.

Preferably, the first and second polarization-maintaining fiber leads provide substantially identical differential optical path differences for the two orthogonal polarization modes.

Preferably, the first and second polarization-maintaining fiber leads are coupled to each other such that the slow principal axis of the first lead is orthogonal to the slow principal axis of the second lead.

Preferably, a principal axis of the first and second polarization-maintaining fiber leads is parallel to a principal axis of the polarization-maintaining optical sensing fiber.

Preferably, the optical phase shift $\phi$ comprises an alternating phase shift term $\theta_0 \sin \omega t$ and a slowly varying phase shift term $\phi_0(t)$ with $\theta_0$ being the amplitude of the alternating term and $\omega$ being the angular frequency of the alternating term.

Preferably, the slowly varying phase shift term $\phi_0(t)$ is generated by at least one of: changes in ambient temperature, a thermal transducer body, a heating element, or at least one piezo-electric element attached to the polarization-maintaining optical sensing fiber or to the first or second polarization-maintaining fiber leads.

Preferably, the alternating phase shift term $\theta_0 \sin \omega t$ is generated by alternating fiber strain, in particular alternating longitudinal fiber strain, exerted onto the polarization-maintaining optical sensing fiber.

Preferably, the slowly varying phase shift term $\phi_0(t)$ varies in a range of angles >90°.

Preferably, the first and second fiber sections provide substantially identical optical path differences $\Delta L$ for the two orthogonal polarization modes.

Preferably, the optical path differences $\Delta L$ of the two orthogonal polarization modes of the first and second polarization-maintaining fiber lead and/or of the first and section of the polarization-maintaining optical sensing fiber differ, in particular by an amount $0 < \Delta L < l_c$, with $l_c$ being the coherence length of the light source.

Preferably, the slowly varying phase shift term $\phi_0(t)$ is generated via a change of the wavelength of the light source in addition to changes in ambient temperature.

Preferably, the fiber-optic sensor further comprises a processor configured to determine the optical phase shift $\phi$ from at least one first light signal Si($\phi$) and at least one second light signal Sj($\phi$) returning from the polarization-maintaining optical sensing fiber through at least two of the M polarizing elements.

Preferably, the processor is configured to determine the slowly varying and alternating components of the at least one first light signal Si($\phi$) and the at least one second light signal Sj($\phi$).

Preferably, the processor is configured to determine the optical phase shift $\phi$, in particular the alternating phase shift term $\theta_0 \sin \omega t$, based on the slowly varying and alternating components and the fringe contrast of the at least one first light signal Si($\phi$) and the at least one second light signal Sj($\phi$), wherein the fringe contrast is determined by calibration or from the maxima and minima, Si max, Si min, Sj max, Sj min, of the at least one first light signal Si($\phi$) and the at least one second light signal Sj($\phi$).

Preferably, the optical sensing fiber is attached to at least one piezoelectric transducer element that generates the optical phase shift $\phi$ under the influence of an electric field.

Preferably, the at least one piezoelectric transducer element is made of or comprises crystalline quartz.

Preferably, the piezoelectric transducer element is of disk shape or annular shape.

Preferably, a crystallographic x-direction is aligned orthogonal to a facet of the disk shaped or annular shaped transducer element.

Preferably, the optical fiber is attached to a series of piezo-electric transducer elements configured equidistantly along a path between a high voltage electrode and a ground potential electrode.

Preferably, a crystallographic x-direction of the piezo-electric transducer elements is aligned parallel to said path.

Preferably, the piezo-electric transducer elements are arranged as pairs of piezo-electric transducer elements along the path between the high voltage electrode and the ground potential electrode.

Preferably, a crystallographic x-direction of the first piezo-electric transducer element of a pair of piezo-electric transducer elements is anti-parallel to a crystallographic x-direction of the second piezo-electric transducer element of said pair of piezo-electric transducer elements.

Preferably, the first section of the optical fiber is attached to the first piezo-electric transducer elements of said pairs of piezo-electric transducer elements and the second section of the optical fiber is attached to the second piezo-electric transducer elements of said pairs of piezo-electric transducer elements.

Preferably, the optical phase shift represents the voltage between the high voltage electrode and ground potential electrode.

The present invention also relates to a method of using a fiber-optic sensor according to any one of the aforementioned preferred embodiments, the method comprises determining the optical phase shift $\phi$ from at least one first light signal $Si(\phi)$ and at least one second light signal $Sj(\phi)$ returning from the polarization-maintaining optical sensing fiber through at least two of the M polarizing elements.

Preferably, the method comprises determining the slowly varying and alternating components of the at least one first light signal $Si(\phi)$ and the at least one second light signal $Sj(\phi)$.

Preferably, the method comprises determining the optical phase shift $\phi$, in particular the alternating phase shift term $\theta_0 \sin \omega t$, based on the slowly varying and alternating components and the fringe contrast of the at least one first light signal $Si(\phi)$ and the at least one second light signal $Sj(\phi)$, wherein the fringe contrast is determined by calibration or from the maxima and minima, Si max, Si min, Sj max, Sj min, of the at least one first light signal $Si(\phi)$ and the at least one second light signal $Sj(\phi)$.

The present invention also relates to a system for measuring an optical phase shift comprising a fiber-optic sensor according to any one of the aforementioned embodiments and at least one piezo-electric transducer element according to any one of the aforementioned embodiments.

BRIEF DESCRIPTION OF THE DRAWINGS

The subject matter of the invention will be explained in more detail in the following text with reference to preferred exemplary embodiments which are illustrated in the attached drawings, in which:

FIG. 1 relates to a configuration of a fiber-optic sensor according to an embodiment of the present disclosure.

FIG. 2 relates to a sensor head according to an embodiment of the present disclosure.

FIG. 3 relates to embodiments of the arrangement the two set of piezo-electric elements with the opposite positive x-directions according to the present disclosure.

FIG. 4 shows an integrated optic polarization splitter/combiner according to an embodiment of the present disclosure.

FIG. 5 shows the interference light signals according to an embodiment of the present disclosure.

FIG. 6 shows a signal processing flow chart according to an embodiment of the present disclosure.

FIG. 7 shows an integrated optic polarization splitter/combiner according to an embodiment of the present disclosure.

FIG. 8 shows an integrated optic polarization splitter/combiner according to an embodiment of the present disclosure.

FIG. 9 shows an integrated optic polarization splitter/combiner according to an embodiment of the present disclosure.

FIG. 10 shows an integrated optic polarization splitter/combiner according to an embodiment of the present disclosure.

FIG. 11 shows fiber-optic sensor in transmission according to an embodiment of the present disclosure.

DETAILED DESCRIPTION OF PREFERRED EMBODIMENTS

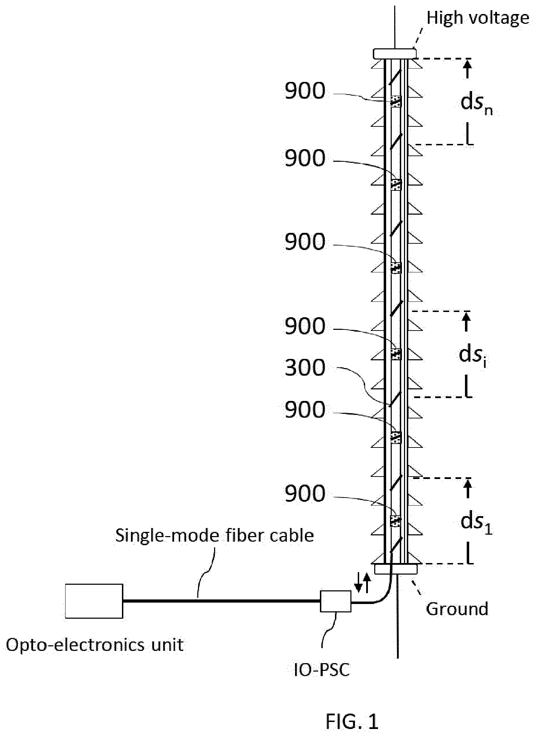

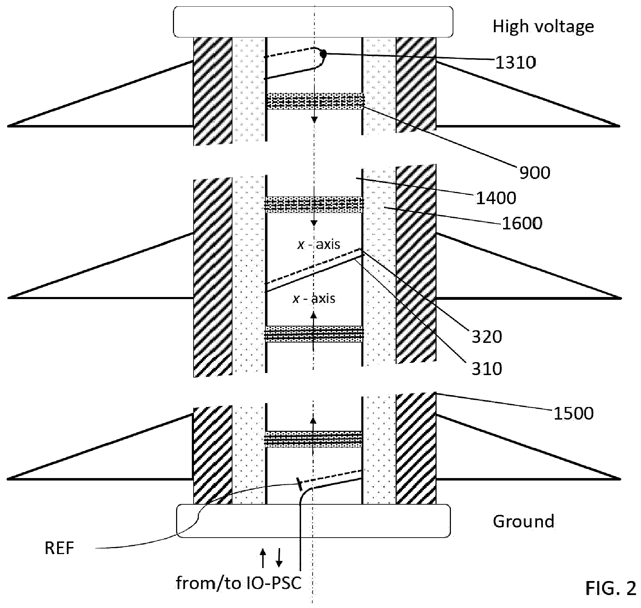

FIGS. 1 and 2 relate to a configuration of a fiber-optic sensor and details of a sensor head (e.g. a primary converter) of the fiber-optic sensor, respectively. The fiber-optic sensor includes an integrated-optic polarization splitter/combiner (IO-PSC) and a polarization maintaining optical sensing fiber 300. As shown in FIG. 1, a path from a ground electrode to a high voltage electrode (e.g. a field integration path or an optical path) consists of n path segments $ds_i$, where i=1, 2, ..., n. For each path segment $ds_i$, a piezo-electric transducer element 900 resides in the middle of each path segment $ds_i$ with a longitudinal axis parallel to the integration path. In an example, the piezo-electric elements 900 may consist of quartzes. As shown in FIG. 2, the longitudinal axis of each piezo-electric element 900 coincides with a 2-fold crystallographic axis (crystallographic x-axis)). The alternating electric field modulates a circumferential length L of each piezo-electric element 900 by a converse piezo-electric effect. For the given orientation, a length change $\Delta L$ on each piezo-electric element 900 is proportional to the field component $E_x$ parallel to x-axis shown in FIG. 2. Note that, orthogonal field components have no influence. The length change $\Delta L$ may be expressed as:

$$\Delta L = -(1/2)d_{11}E_xL \qquad (1)$$

where, $d_{11}$ is a relevant piezo-electric coefficient (e.g. $d_{11} = 2.3 \times 10^{-12}$ m/V). Note that $\Delta L$ may be positive or negative depending whether $E_x$ is parallel or anti-parallel to the x-axis. In FIG. 1 and 2, a number of loops of the polarization maintaining optical sensing fiber 300, which includes 2 fiber sections 310 and 320 as shown in FIG. 2, are wrapped with adequate pre-strain on each of the piezo-electric element 900. For example, 5 to 10 fiber loops of the common polarization maintaining optical sensing fiber 300 may be wrapped on each piezo-electric element 900. In an example, the polarization maintaining optical sensing fiber 300 is a birefringent (polarization-maintaining) fiber supporting the two orthogonal polarization modes of the fundamental mode. The modulation of the polarization maintaining optical sensing fiber 300 strain by the piezo-electric elements 900 in the presence of an alternating electric field results in a corresponding modulation of the differential phase of two orthogonal polarization modes of the polarization maintaining optical sensing fiber 300. The optical phase modulation (e.g. an alternating phase shift term) $\theta$ of the two orthogonal polarization modes may be characterized by its amplitude $\theta_0$, frequency $\omega$, and phase $\varphi$:

$$\theta = \theta_0\sin(\omega t + \varphi) \qquad (2)$$

In an example, the phase $\varphi$ is assumed to be 0 and the optical phase modulation $\theta$, which is a measure for the voltage between the high voltage and the ground potential, can be expressed as:

$$\theta = g\sum E_i \cdot ds_i \qquad (3)$$

where i = 1, 2, ..., n, and g is a conversion factor. That is, the fiber-optic sensor configuration approximates the line integral $\int E \cdot ds$, and hence the voltage between the high voltage and ground potential electrodes, by a sum $\sum E_i \cdot ds_i$. Note that, there may be a residual integration error resulted by this approximation and a sensor calibration may be adopted to eliminate the residual integration error for a given field distribution. The number n of path segments $ds_i$ is chosen large enough so that the residual integration errors remain within specified limits if the field distribution deviates from the given field distribution of the sensor calibration. The sensitivity of the polarization maintaining optical sensing fiber 300 to strain depends of the fiber parameters and wavelength of operation (i.e., the wavelength of the light signal transmitted in the polarization maintaining optical sensing fiber 300). For example, for phase shift of $2\pi$ between the orthogonal polarization modes, a fiber elongation in the range between 0.1 and 2 mm may be required. In an example, the fiber-optic sensor may be designed to produce an optical phase modulation $\theta$ with an amplitude $\theta_0$ on the order of 10 mrad.

In order to cancel or reduce optical phase modulations caused by mechanical perturbations of the fiber-optic sensor, the positive x-directions of the piezo-electric elements 900 alternate from piezo-electric element 900 to piezo-electric element 900. In an example, one half of the piezo-electric elements 900 have their positive x-axis pointing upward and another half of piezo-electric elements 900 have their positive x-axes pointing downward. As shown in FIG. 2, the directions of the piezo-electric elements 900 alternate from piezo-electric element 900 to piezo-electric element 900, wherein the bottom-most piezo-electric element 900 has its positive x-direction pointing upwards and the top-most piezo-electric element 900 has its positive x-direction pointing downwards. That is, the piezo-electric deformations of the two sets of piezo-electric elements 900 are antiphase. Furthermore, the polarization maintaining optical sensing fiber 300 consists of two identical fiber sections 310 and 320 (solid and dashed lines in FIG. 2) that are joined by a 90°-splice 1310. Under such a condition, the slow principal axis of the fiber section 310 is parallel to the fast principal axis of the fiber section 320 and the differential phase shifts of the orthogonal polarization modes in the fiber sections 310 and 320 are of opposite sign at a given fiber strain. In the example shown in FIG. 2, the fiber section 310 interrogates the piezo-electric elements 900 with the positive x-direction pointing upwards, while the fiber section 320 interrogates the piezo-electric elements 900 with the x-direction pointing downwards. As a result, phase shifts produced by the electric field add up for both sets of piezo-electric elements 900 whereas phase shifts caused by mechanical perturbation cancel out. Note that it is assumed that the mechanical perturbations of neighboring piezo-electric elements 900 with opposite x-directions are of the same magnitude and phases.

In an example, the polarization maintaining optical sensing fiber 300 is operated in a reflection-mode. That is, the fiber section 320 is terminated with a reflector REF, e.g. a reflecting coating, and the orthogonal polarization modes pass the fiber sections 310 and 320 twice. The fiber-optic sensor's sensitivity is doubled, therefore. The total differential group delay that the orthogonal modes accumulate in the fiber sections 310 and 320 is zero due the swapping of the principal axes at the 90°-splice 1310. As a result, coherence of the polarization states is restored after each pass through the fiber sections 310 and 320 even though the light source is of low-coherence.

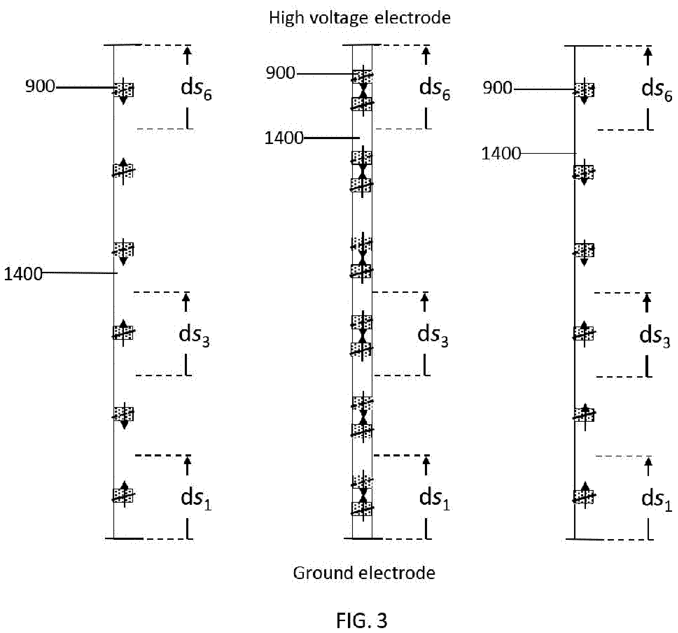

FIG. 3 shows embodiments of the arrangement of the two set of piezo-electric elements 900 with the opposite positive x-directions by using 6 path segments as examples. In the left arrangement shown in FIG. 3, each path segment contains one piezo-electric element 900. The positive and negative x-directions of the piezo-electric elements 900 alternate from path segment to path segment. In middle arrangement shown in FIG. 3, each path segment contains two piezo-electric elements 900 with opposite x-directions. In this example, the distance between the two piezo-electric elements 900 of each path segment may be smaller than a length of each path segment. In the right arrangement shown in FIG. 3, the piezo-electric elements 900 with upward pointing x-directions is arranged in the bottom half of the arrangement and the piezo-electric elements 900 with downward pointing x-directions in the top half of the arrangement. Under such a condition, the 90°-splice 1310 between the two fiber sections 310 and 320 (not shown in FIG. 3) may be between the two sets of piezo-electric elements 900 and the reflector REF is arranged at the high voltage end of the arrangement. In an example, the piezo-electric elements 900 may have a diameter of 30 mm and a thickness of 5 mm.

Note that, the polarization maintaining optical sensing fiber 300 is wrapped onto the piezo-electric elements 900 with an adequate pre-strain. Since a thermal expansion coefficient of the piezo-electric elements 900 is significantly larger than that of the polarization maintaining optical sensing fiber 300, the pre-strain at a room temperature must be sufficiently large so that a minimum strain is still maintained at the smallest operating temperature, e.g., at -40°C. The polarization maintaining optical sensing fiber 300 has a coating that is sufficiently stiff to fully transmit the piezo-electric deformation of the piezo-electric elements 900 onto the polarization maintaining optical sensing fiber 300 over the full temperature range of operation, e.g. between -40 and 85°C. For example, the coatings of the polarization maintaining optical sensing fiber 300 may include coatings from hard acrylate, polyimide, or PEEK (Polyetherether ketone). In an example, the fiber has an outer diameter of 80 $\mu$m, rather than the 125-$\mu$m-diameter which is more standard in telecommunications, in order to limit bend-induced fiber stress.

In FIG. 2, piezo-electric element end faces of the piezo-electric elements 900 may have glued-on steel disks (not shown) which are configured to connect the piezo-electric elements 900 to dielectric spacer elements 1400 (only one dielectric spacer element 1400 is marked for illustrations) in between the piezo-electric elements 900 since the steel and the piezo-electric element 900 have almost identical thermal expansion coefficients. The steel disks and the dielectric spacer elements 1400 may be connected by springs or other flexible elements to ascertain sufficient mechanical flexibility of the fiber-optic sensor configuration, e.g., in case of deformation of the outer insulator tube by wind forces. Alternatively, the dielectric spacer elements 1400 themselves may be made of a flexible material. Instead of steel disks, disks made from a dielectric material may be chosen. The polarization maintaining optical sensing fiber 300 in between the piezo-electric elements 900 may be loosely wrapped onto the circumference of the dielectric spacer elements 1400 or may be guided through the interior of the, preferably hollow, dielectric spacer elements 1400.

The assembly of piezo-electric elements 900 and dielectric spacer elements 1400 forms a sensing body which is mounted in an slender insulator tube 1500, e.g., with a an inner diameter of 40 mm or 50 mm as illustrated in FIG. 1 and 2. A compressible gel or foam 1600 fills the remaining hollow volume of the insulator tube 1500. The insulator tube 1500 may be equipped with corona rings (not shown) for field steering on the high voltage and/or the ground potential ends of the insulator tube 1500.

In the present disclosure, a method of fiber-optic sensor interrogation, i.e., a method to measure the voltage-induced optical phase modulation θ, is disclosed. In an embodiment, a passive integrated-optic polarization splitter/combiner (IO-PSC) (e.g. the IO-PSC shown in FIG. 1) is used for converting the differential optical phase shift $\phi$ between the two orthogonal polarization modes into changes of light intensity, and an opto-electronics unit (e.g. with photo detectors and a processor) then derives the optical phase modulation θ from the changes of light intensity.

Note that, the total differential optical phase shift $\phi$ of the two orthogonal polarization modes includes, besides the alternating term θ = θ$_0$sin(ωt + φ) introduced by the piezo-electric elements, a quasi-static (slowly varying) term $\phi_0$,

which can vary as a function of temperature and time over several multiples of $\pi$. For example, the optical phase $\phi$ may be expressed as:

$$\phi = \theta_0 \sin(\omega t + \varphi) + \phi_0.$$

A variation in $\phi_0$ may be caused, e.g., by a variation of birefringence of waveguides in the IO-PSC with the temperature or by a variation in the birefringence in the two fiber sections 310 and 320 if the birefringent phase shifts in the two fiber sections 310 and 320 are not perfectly balanced. In the followings, the IO-PSC and algorithms are functionalized, such that the opto-electronics unit can unambiguously recover the optical phase modulation $\theta$ even in the presence of the unknown and varying phase shift (e.g. a slowly varying phase shift term) $\phi_0(t)$. The IO-PSC is a passive device and therefore can be made part of the sensor head. As a result, standard single-mode fibers, rather than polarization-maintaining fibers, can be used between the sensing head and opto-electronics unit in contrast to alternative designs that employ active components such as phase modulators. Therefore, manufacture costs of the fiber-optic sensor can be substantially reduced and the field installation of the fiber-optic sensor can be simplified, since splicing of polarization-maintaining fiber in the field is avoided.

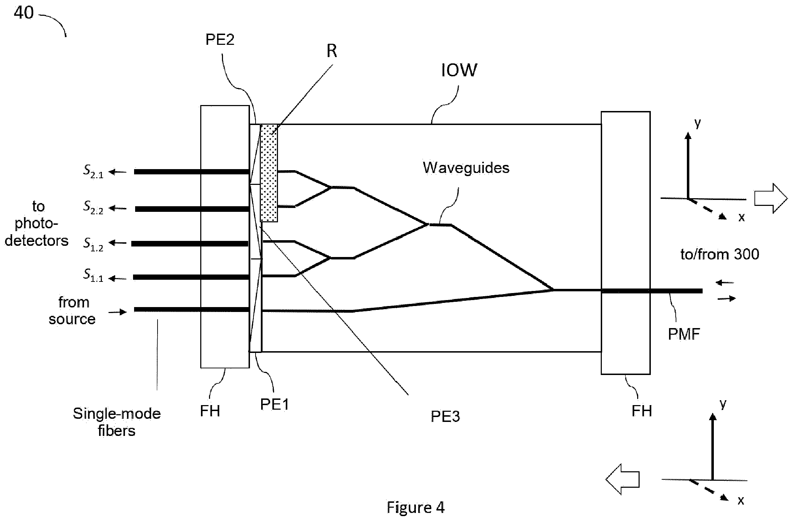

FIG. 4 shows an IO-PSC 40 according to an embodiment of the present disclosure. The IO-PSC 40 may be the IO-PSC shown in FIG. 1. In this example, a broad-band light source (not shown) sends a light signal (e.g. a depolarized light signal) through a single-mode fiber fixed by a fiber holder FH to the IO-PSC 40. The light source may be a superluminescent diode (SLED), e.g., with a center wavelength of 1310 nm and may be part of the opto-electronics unit shown in FIG. 1. In an example, the IO-PSC 40 may be configured at the base (ground potential side) of the fiber-optic sensor configuration shown in FIG. 1. The IO-PSC 40 comprises an integrated optic waveguide beam splitter IOW having a splitter plane and a polarizing element PE1 (e.g. a polarizer platelet) is coupled to a source-side facet of the integrated optic waveguide beam splitter IOW and polarizes the light signal at 45° to the normal of the splitter plane of the integrated optic waveguide beam splitter IOW. After passing through the polarizing element PE1, the light signal enters an input port at the source-side facet of the integrated optic waveguide beam splitter IOW and exits the integrated optic waveguide beam splitter IOW at a sensor-side facet of the integrated optic waveguide beam splitter IOW opposite to the source-side facet. The light signal enters a polarization-maintaining fiber PMF which is fixed by another fiber holder FH coupled to the sensor-side facet of the integrated optic waveguide beam splitter IOW. In this example, a principal axis of the polarization-maintaining fiber PMF is oriented at 0° to the normal of the splitter plane of the integrated optic waveguide beam splitter IOW, so that both orthogonal polarization modes of the polarization-maintaining fiber PMF are exited, e.g., as solid and dashed lines shown in FIG. 4.

The PMF may constitute the fiber section 310 of the polarization maintaining optical sensing fiber 300 or represent an intermediate fiber section between the IO-PSC 40 and the fiber section 310. The integrated optic waveguide beam splitter IOW splits the orthogonal polarization modes returning from the polarization maintaining optical sensing fiber 300 into four detector ports. The orthogonal polarization modes interfere at the polarizing elements PE1, PE2 and PE3 at the source-side facet of the integrated optic waveguide beam splitter IOW. In an example, the polarizing element PE1 has a polarization direction of 45° with respect to the slow axis of the polarization-maintaining fiber PMF, the polarizing element PE2 has a polarization direction of 45° with respect to the slow axis of the polarization-maintaining fiber PMF and the polarizing element PE3 has a polarization direction of -45° with respect to the slow axis of the polarization-maintaining fiber PMF. As a result, there are four interference light signals $S_{1,1}$, $S_{1,2}$, $S_{2,1}$ and $S_{2,2}$ output to the 4 detector ports. A birefringent optical element R (a quarter-wave retarder) with its principal axes parallel and perpendicular to the normal of the integrated optic waveguide beam splitter IOW introduces an extra static phase shift of $(2m-1) \times 90°$ (m is a positive integer) between the orthogonal modes in two of the four detector ports (i.e. the interference light signals $S_{2,1}$ and $S_{22}$). In this example, the birefringent optical element R is oriented such that its principal axis is at 0° with respect to a principal axis of the polarization-maintaining fiber PMF. In an example, the birefringent optical element R is mounted in a stress-free manner in a recess of the source-side facet of the integrated optic waveguide beam splitter IOW.

In the following examples, the principal axes of birefringence generated by waveguides in the integrated optic waveguide beam splitter IOW (if there is any birefringence) are assumed to be parallel and orthogonal to the normal of the splitter plane of the integrated optic waveguide beam splitter IOW. In addition, in the present disclosure, angular tolerances for each angle value may be 15°, 10°, 5° or 1°. For example, a principal axis of the birefringent optical element R may be in a range of 0° ($\pm$15°) with respect to a principal of the polarization-maintaining fiber PMF. In a preferable embodiment, a principal axis is in a range of 0° ($\pm$10°) with respect to a principal of the polarization-maintaining fiber PMF. In a more preferable embodiment, a principal axis is in a range of 0° ($\pm$5°) with respect to a principal axis of the polarization-maintaining fiber PMF. In an even more preferable embodiment, a principal axis is at 0°$\pm$1° with respect to a principal axis of the polarization-maintaining fiber PMF.

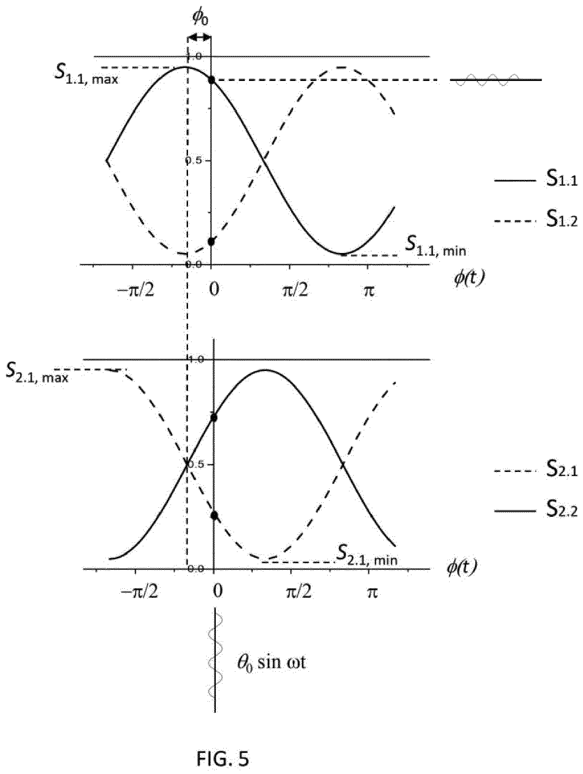

FIG. 5 shows the interference light signals $S_{1,1}$, $S_{1,2}$, $S_{2,1}$ and $S_{2,2}$ according to an embodiment of the present disclosure. In FIG. 5, the interference light signals $S_{1,1}$, $S_{1,2}$, $S_{2,1}$ and $S_{2,2}$ are illustrated as a function of an optical phase shift $\phi$ between the two orthogonal polarization modes at the point of interference.

The interference light signals $S_{1,1}$, $S_{1,2}$ may be expressed as:

$$S_{1,1} = \frac{1}{2} A_{1,1} \left[ 1 + K_{1,1} \cos(\theta_0 \sin \omega t + \phi_0(t)) \right] \qquad (4)$$

$$S_{1,2} = \frac{1}{2} A_{1,2} \left[ 1 - K_{1,2} \cos(\theta_0 \sin \omega t + \phi_0(t)) \right] \qquad (5)$$

Similarly, the interference light signals $S_{2,1}$, $S_{2,2}$ may be expressed as:

$$S_{2,1} = \frac{1}{2} A_{2,1} \left[ 1 + K_{2,1} \sin(\theta_0 \sin \omega t + \phi_0(t)) \right] \qquad (6)$$

$$S_{2,2} = \frac{1}{2} A_{2,2} \left[ 1 - K_{2,2} \sin(\theta_0 \sin \omega t + \phi_0(t)) \right] \qquad (7)$$

where $A_{1,1}$, $A_{1,2}$, $A_{2,1}$ and $A_{2,2}$ are the signal amplitudes which depend on the power of the light source and losses in the opto-electronics unit and $K_{1,1}$, $K_{1,2}$, $K_{2,1}$ and $K_{2,2}$ represent the fringe contrast of the four interference light signals. Ideally, the fringe contrast is equal to unity but in practice may differ from unity in case of unequal amplitude of the interfering polarization modes or only partial coherence. As already mentioned above, $\theta_0$ and $\omega$ are the amplitude and frequency of the phase modulation $\theta$ (i.e., $\theta = \theta_0 \sin \omega t$) generated by the voltage to be measured, and $\phi_0(t)$ is a quasi-static (slowly varying) phase shift between the orthogonal polarization modes. The extra static phase shift (phase bias) introduced by the birefringent optical element R at the detector ports of the interference light signals $S_{2,1}$, $S_{2,2}$ is accounted for by the sine-terms in the equations (6) and (7) instead of the cosine terms in the equations (4) and (5).

The functions (4) to (7) may be expanded and become:

$$S_{1,1} = \frac{1}{2} A_{1,1} \left\{ 1 + K_{1,1} \left[ \cos(\theta_0 \sin \omega t) \cos(\phi_0(t)) - \sin(\theta_0 \sin \omega t) \sin(\phi_0(t)) \right] \right\} \quad (8)$$

$$S_{1,2} = \frac{1}{2} A_{1,2} \left\{ 1 - K_{1,2} \left[ \cos(\theta_0 \sin \omega t) \cos(\phi_0(t)) - \sin(\theta_0 \sin \omega t) \sin(\phi_0(t)) \right] \right\} \quad (9)$$

$$S_{2,1} = \frac{1}{2} A_{2,1} \left\{ 1 + K_{2,1} \left[ \sin(\theta_0 \sin \omega t) \cos(\phi_0(t)) + \cos(\theta_0 \sin \omega t) \sin(\phi_0(t)) \right] \right\} \quad (10)$$

$$S_{2,2} = \frac{1}{2} A_{2,2} \left\{ 1 - K_{2,2} \left[ \sin(\theta_0 \sin \omega t) \cos(\phi_0(t)) + \cos(\theta_0 \sin \omega t) \sin(\phi_0(t)) \right] \right\} \quad (11)$$

In general, the amplitude $\theta_0$ is small (e.g., smaller than 0.1 rad) and signal components (or alternating current (AC) components) of the interference light signals $S_{1,1}$, $S_{1,2}$, $S_{2,1}$ and $S_{2,2}$ at the frequency $\omega$ can be expressed as:

$$S_{1,1}^{(\omega)} = -\frac{1}{2} A_{1,1} K_{1,1} \theta_0 \sin(\phi_0(t)) \qquad (12)$$

$$S_{1,2}^{(\omega)} = \frac{1}{2} A_{1,2} K_{1,2} \theta_0 \sin(\phi_0(t)) \qquad (13)$$

$$S_{2,1}^{(\omega)} = -\frac{1}{2} A_{2,1} K_{2,2} \theta_0 \cos(\phi_0(t)) \qquad (14)$$

$$S_{2,2}^{(\omega)} = \frac{1}{2} A_{2,2} K_{2,2} \theta_0 \cos(\phi_0(t)) \qquad (15)$$

Note that, more precisely, an expansion of the equations (4) to (7) by means of Bessel functions yields $2J_1(\theta_0)$ instead merely $\theta_0$ in the equations (8) to (11). However, the difference is negligible when the amplitude $\theta_0$ is sufficiently small.

In addition, direct current (DC) components of the interference light signals $S_{1,1}$, $S_{1,2}$, $S_{2,1}$ and $S_{2,2}$ can be expressed as:

$$S_{1,1}^{(DC)} = \frac{1}{2} A_{1,1} \left[ 1 + K_{1,1} \cos(\phi_0(t)) \right] \qquad (16)$$

$$S_{1,2}^{(DC)} = \frac{1}{2} A_{1,2} \left[ 1 - K_{1,2} \cos(\phi_0(t)) \right] \qquad (17)$$

$$S_{2,1}^{(DC)} = \frac{1}{2} A_{2,1} \left[ 1 + K_{2,1} \sin(\phi_0(t)) \right] \qquad (18)$$

$$S_{2,2}^{(DC)} = \frac{1}{2} A_{2,2} \left[ 1 - K_{2,2} \sin(\phi_0(t)) \right] \qquad (19)$$

For further processing, the opto-electronics unit equalizes the two interference light signals of each interference light signal pair (i.e. the interference light signals $S_{1,1}$ and $S_{1,2}$ or the interference light signals $S_{2,1}$ and $S_{2,2}$), to equal amplitudes.

In an embodiment, the first and second interference light signals of each signal pair are normalized by multiplying the first interference light signal with the AC component at frequency $\omega$ of the second interference light signal, and the second interference light signal is normalized by multiplying the second interference light signal with the AC component at frequency $\omega$ of the first interference light signal. For example, the AC and DC components of the normalized interference light signals $S_{1,1}$ and $S_{1,2}$ can be expressed as:

$$S_{1,1}^{(\omega)} = -\frac{1}{4} A_{1,1} K_{1,1} A_{1,2} K_{1,2} (\theta_0 \sin \phi_0(t))^2 \qquad (20)$$

$$S_{1,2}^{(\omega)} = \frac{1}{4} A_{1,1} K_{1,1} A_{1,2} K_{1,2} (\theta_0 \sin \phi_0(t))^2 \qquad (21)$$

$$S_{1,1}^{(DC)} = \frac{1}{4} A_{1,1} A_{1,2} K_{1,2} \theta_0 \sin \phi_0 \left[ 1 + K_{1,1} \cos(\phi_0(t)) \right] \qquad (22)$$

$$S_{1,2}^{(DC)} = \frac{1}{4} A_{1,2} A_{1,1} K_{1,1} \theta_0 \sin \phi_0 \left[ 1 - K_{1,2} \cos(\phi_0(t)) \right] \qquad (23)$$

According to the equations (20) to (23), a normalized signal S' which is independent from the optical power terms $A_{1,1}$ and $A_{1,2}$ can be acquired by dividing the difference of the AC components of the interference light signals $S_{1,1}$ and $S_{1,2}$ by the sum of the DC components of the interference light signals $S_{1,1}$ and $S_{1,2}$ :

$$S' = \left(S_{1,1}^{(\omega)} - S_{1,2}^{(\omega)}\right)/\left(S_{1,1}^{(DC)} + S_{1,2}^{(DC)}\right) = -K\theta_0(\sin(\phi_0(t))) \quad (24)$$

where $K=K_{1,1}=K_{1,2}$ is assumed.

The interference light signals $S_{2,1}$ and $S_{2,2}$ may be normalized by similar manners and a normalized signal S" which is independent from the optical power terms $A_{2,1}$ and $A_{2,2}$ can be acquired as:

$$S'' = -K\theta_0(\cos(\phi_0(t))) \quad (25)$$

where $K= K_{2,1}=K_{2,2}$ is assumed. Therefore, the unknown phase shift $\phi_0(t)$ can be acquired by:

$$\phi_0(t) = \tan^{-1}(S'/S'') \quad (26)$$

On the other hands, the values of $K_i$ related to the fringe contrast may be acquired by dividing a difference of the maximum value $S_{i,max}$ and the minimum value $S_{i,min}$ of the interference light signal Si by a sum of the maximum value $S_{i,max}$ and the minimum value $S_{i,min}$ of the interference light signal $S_i$ (i=1,1, 1,2, 2,1 and 2.2):

$$K_i = \left(S_{i,max} - S_{i,min}\right)/\left(S_{i,max} + S_{i,min}\right) \quad (27)$$

The examples of the maximum value and the minimum value of the interference light signal $S_i$ (i=1,1, 1,2, 2,1 and 2.2) can refer to FIG. 5. Based on FIG. 5, the maximum value $S_{i,max}$ and the minimum value $S_{i,min}$ may be expressed as:

$$S_{i,max} = \frac{1}{2} A_i(1 + K_i) \quad (28)$$

$$S_{i,min} = \frac{1}{2} A_i(1 - K_i) \quad (29)$$

Note that, the values of $K_i$ (i=1,1, 1,2, 2,1 and 2.2) may be determined by calibration measures.

In an example, when the phase shift $\phi_0(t)$ and K are determined, the amplitude $\theta_0$ can be acquired from the equations (24) and (25), and then the voltage which the fiber-optic sensor designed to measure (e.g. the voltage difference between the high voltage and the ground potential) can be acquired. In an example, the phase shift $\phi_0(t)$ is determined based on the equation (24) if the phase shift $\phi_0(t)$ is in a range (4m - 1) $\pi/4 < \phi_0(t) \le$ (4m+ 1) $\pi/4$ (with m being an integer); and the phase shift $\phi_0$ is determined based on the equation (25)) if the phase shift $\phi_0(t)$ is in a range (4m + 1) $\pi/4 < \phi_0(t)$ $\le$ (4m+ 3) $\pi/4$ (with m being an integer). That is, if the absolute value of cos(($\phi_0(t)$) is between $\frac{1}{\sqrt[2]{2}}$ and 1, the phase shift $\phi_0(t)$ is determined based on the equation (24); and if the absolute value of sin($\phi_0(t)$) is between $\frac{1}{\sqrt[2]{2}}$ and 1, the phase shift $\phi_0(t)$ is determined based on the equation (25).

In order to prevent random switching between the two regimes at times when $\phi_0(t)$ is near the boundaries (i.e. (4m - 1) $\pi/4$ or (4m + 1) $\pi/4$), appropriate dead zones may be appropriately designed around the boundaries. In an example, if the phase shift $\phi_0$ enters a dead zone from one side of the boundary, the method of determining the phase shift $\phi_0(t)$ is switched only when phase shift $\phi_0(t)$ leaves the dead zone at the opposite side of the boundary and is not switched when the phase shift $\phi_0(t)$ leaves the dead zone at the side of entering. In an example, the width of the dead zones may be chosen, e.g., as 5° or 10°.

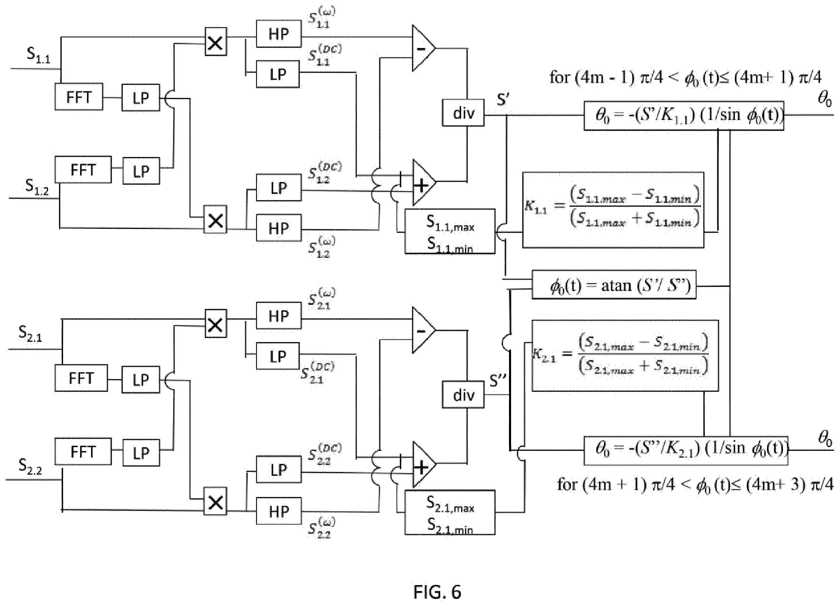

According to different design concepts, various processes of acquiring the phase modulation $\theta_0$ can be implemented based on the equations (4) to (27). FIG. 6 shows a signal processing flow chart according to an embodiment of the present disclosure. For example, the AC components at frequency $\omega$ of the interference light signals $S_{1,1}$, $S_{1,2}$, $S_{2,1}$ and $S_{2,2}$ used for the normalization of the interference light signals are extracted by passing a fast Fourier transform functional block FFT and a low pass filter LP. The low pass filter LP, e.g., with a cutoff frequency of 1 Hz, is configured to average the filtered signals over a certain time period for better stability. However, other concepts such as a bandpass filter or a lock-in technique could be applied. Note that, HP represents a high pass filter HP.

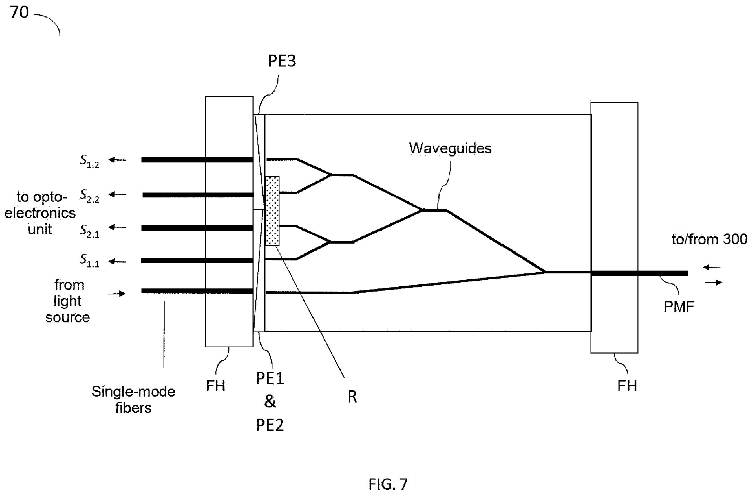

FIG. 7 shows an example of an IO-PSC 70 according to an embodiment of the present disclosure. The IO-PSC 70 is similar to the IO-PSC 40, thus the components with the similar functions use the same symbols. In comparison with the IO-PAC 40, the IO-PSC 70 changes the configurations of the polarizing elements PE1, PE2, PE3 and the birefringent optical element R. Under such a condition, the polarizing elements PE1 and PE2 can be realized by single polarizing element.

In details, the birefringent optical element R changes to be configured to the middle of the detector ports. Because the configurations of the polarizing elements PE1, PE2, PE3, the birefringent optical element R, the polarization-maintaining fiber PMF are the same with those of the IO-PSC 40, the sequence of the signals of the detector ports becomes $S_{1,2}$, $S_{2,2}$, $S_{2,1}$ and $S_{1,1}$ from top to bottom.

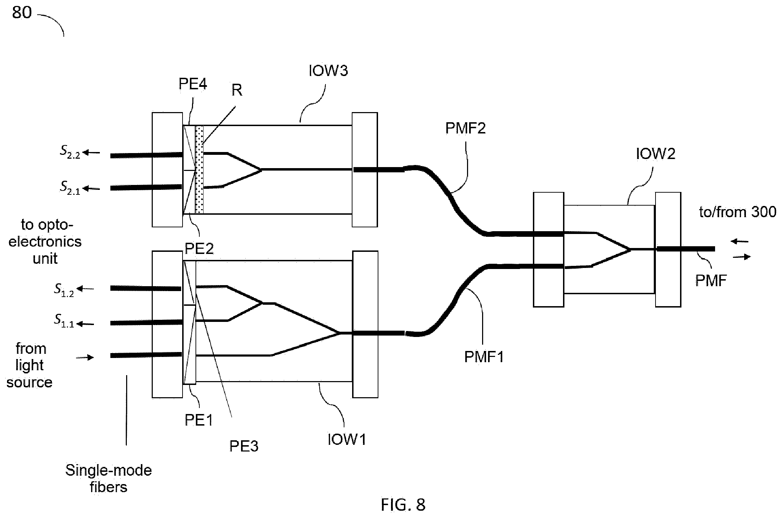

FIG. 8 shows an IO-PSC 80 according to an embodiment of the present disclosure. The IO-PSC 80 is similar to the IO-PSC 40, thus the components and signals with the similar functions use the same symbols. In this embodiment, multiple integrated-optic waveguide beam splitters IOW1, IOW2 and IOW3 are used. Under such a condition, polarization-maintaining fibers PMF1 and PMF2 are added to transmit and/or receive the light signal between the integrated-optic waveguide beam splitters IOW1 and IOW2 or between the integrated-optic waveguide beam splitters IOW2 and IOW3. In addition, a polarizing element PE4 with the same configurations of the polarizing element PE3 is coupled to the birefringent optical element R.

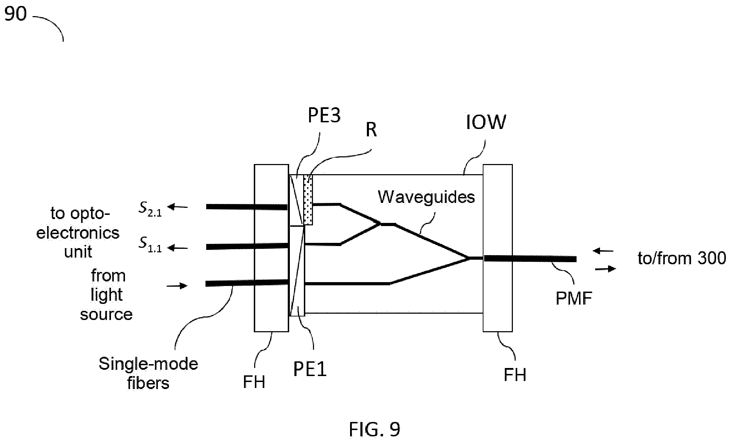

FIG. 9 shows an IO-PSC 90 according to an embodiment of the present disclosure. The IO-PSC 90 is similar to the IO-PSC 40 shown in FIG. 4, thus the components and signals with the similar functions use the same symbols. Different from the IO-PSC 40, the IO-PSC 90 has 2 detector ports corresponding to the interference light signals $S_{1,1}$ and $S_{2,1}$. Under such a condition, the IO-PSC 90 changes to have 2 polarizing element PE1 and PE3. The configurations of the polarizing elements PE1, PE3, the birefringent optical element R, the phase-maintaining fiber PMF are the same with those of the IO-PSC 40.

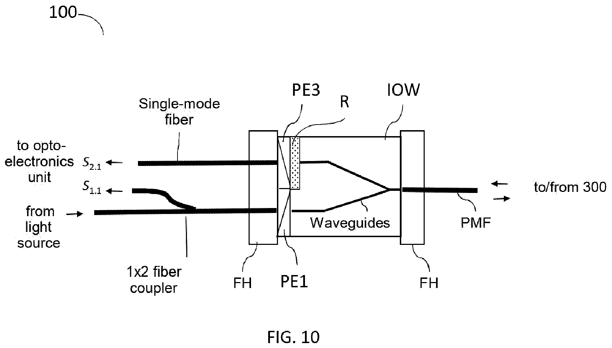

FIG. 10 shows an IO-PSC 100 according to an embodiment of the present disclosure. The IO-PSC 100 is similar to IO-PSC 90, thus the components and signals with the similar functions use the same symbols. In comparison with the IO-PSC 90, the single-mode fiber of the IO-PSC 100 for connecting to the light source includes a 1x2 fiber coupler for outputting the interference light signal $S_{1,1}$. The configurations of the polarizing elements PE1, PE3, the birefringent optical element R, the phase-maintaining fiber PMF are the same with those of the IO-PSC 40.

In the embodiments shown in FIGS. 9 and 10, only the interference light signals $S_{1,1}$ and $S_{2,1}$ are output to the opto-electronics unit (i.e., the photo detectors). Under such a condition, the method of normalizing the interference light signals $S_{1,1}$ and $S_{2,1}$ by the AC components of the interference light signals $S_{1,2}$ and $S_{2,2}$ can not be applied. In an example, the interference light signals $S_{1,1}$ and $S_{2,1}$ are normalized by averages $S_{1,1,av}$ and $S_{2,1,av}$ of the interference light signals $S_{1,1}$ and $S_{2,1}$ and the averages $S_{1,1,av}$ and $S_{2,1,av}$ may be expressed as:

$$S_{1,1,av} = \frac{1}{2}\left(S_{1,1,max} + S_{1,1,min}\right) \qquad (30)$$

$$S_{2,1,av} = \frac{1}{2}\left(S_{2,1,max} + S_{2,1,min}\right) \qquad (31)$$

Where, the maximum values $S_{1,1,max}$ and $S_{2,1,max}$ and the minimum values $S_{1,1,min}$ and $S_{2,1,min}$ may be acquired based on the equations (28) and (29). Hence, the averages $S_{1,1,av}$ and $S_{2,1,av}$ become:

$$S_{1,1,av} = \frac{1}{2}A_{1,1} \qquad (32)$$

$$S_{2,1,av} = \frac{1}{2}A_{2,1} \qquad (33)$$

In an example, the AC components at frequency $\omega$ of the interference light signals S1,1 and S2,1 normalized by the averages $S_{1,1,av}$ and $S_{2,1,av}$, may be expressed as:

$$S_{1,1}^{(\omega)} = -\frac{1}{2} K_{1,1}\theta_0 \sin \phi_0(t) \qquad (34)$$

$$S_{2,1}^{(\omega)} = -\frac{1}{2} K_{2,1}\theta_0 \cos \phi_0(t) \qquad (35)$$

Based on the equations (34) and (35), the values of Ki, $\phi_0(t)$ and $\theta_0$ may be determined by similar manners of the aforementioned method..

In an embodiment, the maximum value $S_{i,max}$ and the minimum value $S_{i,min}$ of the interference light signal Si (i=1,1, 1,2, 2,1 or 2,2) may be required to be recorded. Under such a condition, the phase shift $\phi_0(t)$ must frequently vary within a range of at least 180° such that the maximum value $S_{i,max}$ and the minimum value $S_{i,min}$ can be recorded with sufficient frequency.

In an embodiment, the fiber sections 310 and 320 are chosen with different lengths, i.e., different modal path differences $\Delta L$, for acquiring the phase shift $\phi_0(t)$ with sufficiently large variations. Under such a condition, temperature-dependent variations in the phase shifts, $\phi_{01}(t)$ and $\phi_{02}(t)$ of the two fiber sections 310 and 320 are then no longer fully balanced so that the total offset, i.e., $\phi_0(t)$, varies with temperature. Therefore, the maximum value $S_{i,max}$ and the minimum value $S_{i,min}$ can be recorded with sufficient frequency if the fiber sections 310 and 320 are exposed to varying environmental temperature.

In an embodiment, the fiber sections 310 and 320 having the same fiber lengths and several loops of one of the fiber sections 310 and 320 are wrapped onto a disk or cylinder, e.g., made from aluminum. The changes in the phase shift $\phi_0$ of the fiber section wrapped onto the aluminum disk or cylinder at changing ambient temperature become significantly larger, so as to acquire the large variation in the total phase shift $\phi_0$. Furthermore, changes in the IO-PSC waveguide birefringence, if any, give rise to variations in the phase shift $\phi_0(t)$.

In an embodiment, the variation in the phase shift $\phi_0$ can be enhanced by heating one of the fiber sections 310 and 320 (or the aforementioned metal disk with fiber) from the ambient temperature to a certain maximum temperature (e.g., 65 °C) by means of heating foils or other heating means with subsequent passive cooling back to the ambient temperature. In an example, the means for changing the temperature include Peltier coolers. In an example, the phase shift $\phi_0$ varies in a range of angles > 180° according to the changes of the ambient temperature in a temperature range of operations, e.g., the range between -40°C and 85°C.

In an embodiment, the variation in the phase shift $\phi_0$ may be achieved by wrapping one of the fiber sections 310 and 320 onto a tube-like or disk-like transducer, e.g., made from a piezo-electric ceramic (PZT). The phase shift $\phi_0(t)$ may vary with a voltage connected to the PZT transducer. In an example, the voltage driving the PZT transducer can be generated from the power line electric field via a pick-up capacitor.

In an example, the phase shift $\phi_0$ is varied by a modulation of the wavelength $\lambda$ of the source light signal. In this example, the lengths of the two fiber sections 310 and 320 may be different (so that the two fiber sections 310 and 320 have different modal path imbalances) so as to generate a net total path difference $\Delta L_{net} > 0$ between the orthogonal polarization modes. Note that, the net total optical path difference $\Delta L_{net}$ is preferably chosen smaller than the coherence length $l_c$ of the light source (i.e. $0 < \Delta L_{net} < l_c$). A shift in the wavelength $\lambda$ of the source light signal changes the phase shift $\phi_0$ according to:

$$\delta\phi_0(t) = -2\pi(\Delta L_{net}/\lambda^2)d\lambda \qquad (36)$$

The wavelength $\lambda$ can be varied by changing the source temperature by means of the built-in thermo-electric cooler and/or by changing a drive current of the light source (e.g. SLED). In an example of the SLED whose wavelength is 1310 nm, a temperature change of 1°C shifts the center wavelength of the SLED by up to 0.7 nm. If a group delay difference $\Delta L_{net}$ of 40 $\mu$m (about one coherence length) is introduced between the orthogonal polarization modes, a wavelength shift of 25 nm shifts the phase shift $\phi_0(t)$ over a range of about 3.5 rad (the corresponding source temperature span is about 36 °C). Note that, a change in temperature of the light source also changes the output power of the light source.

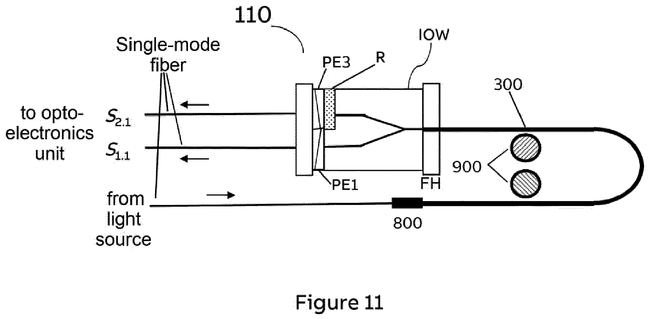

FIG. 11 shows fiber-optic sensor in transmission comprising an IO-PSC 110 according to an embodiment of the present disclosure. The fiber-optic sensor in transmission comprises an integrated-optic waveguide beam splitter

IOW having a first port at a first side and two second ports at a second side. Two polarizing elements PE1 and PE3 are coupled to the second side of the integrated-optic waveguide beam splitter IOW. The second side has two single-mode fibers connected which are connected to the opto-electronics unit. A birefringent optical element R is arranged between the polarizing element PE3 and one port of the second side of the integrated-optic waveguide beam splitter IOW. A polarization-maintaining optical sensing fiber 300 having slow and fast principal axes has its first end coupled to the first port of the integrated-optic waveguide beam splitter IOW. A second end of the polarization-maintaining fiber 300 is connected to another polarizing element 800 which is connected to the light source, in this embodiment a broadband light source.

The polarizing element PE3 has a polarization direction of 45° or -45° with respect to the slow axis of the polarization-maintaining optical sensing fiber 300 whereas the polarizing element PE1 has a polarization direction of 45° with respect to the slow axis of the polarization-maintaining optical sensing fiber 300.

According to the embodiment shown in FIG. 11, a principal axis of the birefringent optical element R is oriented at 0° with respect to the slow axis of the polarization-maintaining optical sensing fiber 300. The birefringent optical element R introduces a birefringent phase delay in a range of $(2m -1) \times 90° (\pm15°)$, where m is a positive integer. The another polarizing element 800 has a polarization direction of 45° with respect to the principal axis of the polarization-maintaining optical sensing fiber 300. In this embodiment, the optical sensing fiber 300 is attached to two piezoelectric transducer elements 900 that generate the optical phase shift $\phi$ under the influence of an electric field which then can be measured by the fiber-optic sensor according to the embodiment of FIG. 11.

LIST OF REFERENCE NUMBERS

[0093]

| | |
|---|---|
| 40, 70, 80, 90, 100 | IO-PSC |
| 300 | polarization maintaining optical sensing fiber |
| 310, 320 | fiber sections |
| 800 | polarizing element |
| 900 | piezo-electric transducer element |
| 1310 | 90°-splice |
| 1400 | dielectric spacer element |
| 1500 | insulator tube |
| 1600 | compressible gel or foam |
| | |
| R | birefringent optical element |
| IOW1, ..., IOWN | integrated-optic waveguide beam splitter |
| PE1, ..., PEM | polarizing element |

**Claims**

1.  A fiber-optic sensor for measuring an optical phase shift $\phi$ between two orthogonal polarization modes of a polarization-maintaining optical sensing fiber (300), comprising:

    an integrated-optic waveguide beam splitter (IOW) having a first port at a first side and N second ports at a second side, the first and second side being preferably opposite to each other, N being a positive integer N ≥ 2, and the integrated-optic waveguide beam splitter (IOW) having a splitter plane;
    M polarizing elements (PE1, PE2, ... PEM) M being a positive integer M ≥ 2, coupled to the second side of the integrated-optic waveguide beam splitter (IOW);
    a birefringent optical element (R) arranged between at least one of the M polarizing elements (PE1, PE2, ... PEM) and at least one port of the N ports of the second side of the 1 x N integrated-optic waveguide beam splitter (IOW);
    a polarization-maintaining optical sensing fiber (300) having slow and fast principal axes and having a first end coupled to the first port of the integrated-optic waveguide beam splitter (IOW) and a second end connected to a reflector,
    wherein at least one of the M polarizing elements (PE1, PE2, ... PEM) is configured to receive a light signal from a light source, in particular a broadband light source, such that the light signal is sent through one of the second ports to the polarization-maintaining optical sensing fiber (300),
    wherein the M polarizing elements (PE1, PE2, ... PEM) have polarization directions of 45° ($\pm$15°) or -45° ($\pm$15°)

with respect to the slow axis of the polarization-maintaining optical sensing fiber (300),
wherein a principal axis of the birefringent optical element (R) is oriented at 0° (±15°) with respect to the slow axis of the polarization-maintaining optical sensing fiber (300),
wherein the birefringent optical element (R) is configured to introduce a birefringent phase delay in a range of $(2m - 1) \times 90°$ (±15°), where m is a positive integer.

2.  A fiber-optic sensor for measuring an optical phase shift $\phi$ between two orthogonal polarization modes of a polarization-maintaining optical sensing fiber (300), comprising:

   an integrated-optic waveguide beam splitter (IOW) having a first port at a first side and N second ports at a second side, the first and second side being preferably opposite to each other, N being a positive integer N ≥ 2, and the integrated-optic waveguide beam splitter (IOW) having a splitter plane;
   M polarizing elements (PE1, PE2, ... PEM) M being a positive integer M ≥ 2, coupled to the second side of the integrated-optic waveguide beam splitter (IOW);
   a birefringent optical element (R) arranged between at least one of the M polarizing elements (PE1, PE2, ... PEM) and at least one port of the N ports of the second side of the 1 x N integrated-optic waveguide beam splitter (IOW);
   a polarization-maintaining optical sensing fiber (300) having slow and fast principal axes and having a first end coupled to the first port of the integrated-optic waveguide beam splitter (IOW) and a second end connected to another polarizing element (800) which is connected to a light source, in particular a broadband light source;
   wherein the M polarizing elements (PE1, PE2, ... PEM) have polarization directions of 45° (±15°) or -45° (±15°) with respect to the slow axis of the polarization-maintaining optical sensing fiber (300),
   wherein a principal axis of the birefringent optical element (R) is oriented at 0° (±15°) with respect to the slow axis of the polarization-maintaining optical sensing fiber (300), and
   wherein the birefringent optical element (R) is configured to introduce a birefringent phase delay in a range of $(2m - 1) \times 90°$ (±15°), where m is a positive integer, and wherein the another polarizing element (800) has a polarization direction of 45° (±15°) with respect to a principal axis of the polarization-maintaining optical sensing fiber (300).

3.  The fiber-optic sensor of claim 1 or 2, wherein the slow axis of the polarization-maintaining optical sensing fiber (300) is oriented at 0° (±15°) or 90° (±15°) with respect to the normal of the splitter plane.

4.  The fiber-optic sensor according to any one of claims 1 to 3, wherein the polarization-maintaining optical sensing fiber (300) comprises a first section and a second section,
   wherein the first and second fiber sections are preferably coupled to each other such that the slow principal axis of the first section is orthogonal to the slow principal axis of the second section.

5.  The voltage sensing device of any one of claims 1 to 4, wherein the birefringent optical element (R) is provided in a recess of the integrated-optic waveguide beam splitter (IOW).

6.  The fiber-optic sensor according to any one of claims 1 to 5, wherein the first end of the polarization-maintaining optical sensing fiber (300) is coupled to the first port of the integrated-optic waveguide beam splitter (IOW) by a first polarization-maintaining fiber lead and a second polarization-maintaining fiber lead, wherein
   the first and second polarization-maintaining fiber leads provide substantially identical differential optical path differences for the two orthogonal polarization modes,
   the first and second polarization-maintaining fiber leads are coupled to each other such that the slow principal axis of the first lead is orthogonal to the slow principal axis of the second lead, and
   a principal axis of the first and second polarization-maintaining fiber leads is parallel to a principal axis of the polarization-maintaining optical sensing fiber (300).

7.  The fiber-optic sensor according to any of claims 1 to 6,
   wherein the optical phase shift $\phi$ comprises an alternating phase shift term $\theta_0 \sin \omega t$ and a slowly varying phase shift term $\phi_0(t)$ with $\theta_0$ being the amplitude of the alternating term and $\omega$ being the angular frequency of the alternating term, and
   wherein preferably the slowly varying phase shift term $\phi_0(t)$ is generated by at least one of:

   changes in ambient temperature,
   a thermal transducer body,

a heating element, or
at least one piezo-electric element attached to the polarization-maintaining optical sensing fiber (300) or to the first or second polarization-maintaining fiber leads.

8. The fiber-optic sensor according to claim 7, wherein
the slowly varying phase shift term $\phi_0(t)$ varies in a range of angles >90°.

9. The fiber-optic sensor according to any one of claims 4 to 8, wherein the first and second fiber section provide substantially identical optical path differences $\Delta L$ for the two orthogonal polarization modes.

10. The fiber-optic sensor according to any one of claims 4 to 8, wherein
the optical path differences $\Delta L$ of the two orthogonal polarization modes of the first and second polarization-maintaining fiber lead and/or of the first and section of the polarization-maintaining optical sensing fiber (300) differ, in particular by an amount $0 < \Delta L < l_c$, with $l_c$ being the coherence length of the light source, and wherein the slowly varying phase shift term $\phi_0(t)$ is generated via a change of the wavelength of the light source in addition to changes in ambient temperature.

11. The fiber-optic sensor of any one of claims 1 to 10, further comprising a processor configured to determine the optical phase shift $\phi$ from at least one first light signal Si($\phi$) and at least one second light signal Sj($\phi$) returning from the polarization-maintaining optical sensing fiber (300) through at least two of the M polarizing elements (PE1, PE2, ... PEM).

12. The fiber-optic sensor of claim 11, wherein the processor is configured to determine the slowly varying and alternating components of the at least one first light signal Si($\phi$) and the at least one second light signal Sj($\phi$) and to determine the optical phase shift $\phi$, in particular the alternating phase shift term $\theta_0 \sin \omega t$, based on the slowly varying and alternating components and the fringe contrast of the at least one first light signal Si($\phi$) and the at least one second light signal Sj($\phi$), wherein the fringe contrast is determined by calibration or from the maxima and minima, Si max, Si min, Sj max, Sj min, of the at least one first light signal Si($\phi$) and the at least one second light signal Sj($\phi$).

13. The fiber-optic sensor according to claims 1 to 12, wherein the optical sensing fiber (300) is attached to at least one piezoelectric transducer element (900) that generates the optical phase shift $\phi$ under the influence of an electric field, in particular
wherein the at least one piezoelectric transducer element (900) is preferably made of or comprises crystalline quartz, the piezoelectric transducer element (900) is preferably of disk shape or annular shape and
a crystallographic x-direction preferably is aligned orthogonal to a facet of the disk shaped or annular shaped transducer element (900).

14. The fiber-optic sensor according to claim 13, wherein
the optical fiber is attached to a series of piezo-electric transducer elements (900) configured equidistantly along a path between a high voltage electrode and a ground potential electrode,
wherein a crystallographic x-direction of the piezo-electric transducer elements (900) is aligned parallel to said path, the piezo-electric transducer elements (900) are arranged as pairs of piezo-electric transducer elements (900) along the path between the high voltage electrode and the ground potential electrode, and wherein
a crystallographic x-direction of the first piezo-electric transducer element (900) of a pair of piezo-electric transducer elements (900) is anti-parallel to a crystallographic x-direction of the second piezo-electric transducer element (900) of said pair of piezo-electric transducer elements (900), and
the first section of the optical fiber is attached to the first piezo-electric transducer elements (900) of said pairs of piezo-electric transducer elements (900) and the second section of the optical fiber is attached to the second piezo-electric transducer elements (900) of said pairs of piezo-electric transducer elements (900), and wherein
the optical phase shift represents the voltage between the high voltage electrode and ground potential electrode.

15. A system for measuring an optical phase shift comprising a fiber-optic sensor according to any one of claims 1 to 13 and at least one piezo-electric transducer element according to claim 13 or 14.

FIG. 1

High voltage

1310

900

1400

1600

x - axis

x - axis

320

310

1500

Ground

REF

from/to IO-PSC

FIG. 2

High voltage electrode

Ground electrode

FIG. 3

Figure 4

FIG. 5

FIG. 6

FIG. 7

FIG. 8

90

PE3
R
IOW

to opto-
electronics
unit

$S_{2.1}$

$S_{1.1}$

Waveguides

from
light
source

Single-mode
fibers

FH

PE1

FH

PMF

to/from 300

FIG. 9

EP 3 772 655 A1

24

EP 3 772 655 A1

100

PE3  R  IOW

Single-mode fiber

to opto-electronics unit  $S_{2.1}$

$S_{1.1}$

from light source

to/from 300

PMF

Waveguides

FH  PE1  FH

1x2 fiber coupler

FIG. 10

**110**

Single-mode fiber

to opto-electronics unit

$S_{2.1}$

$S_{1.1}$

from light source

PE3  R  IOW

PE1  FH

300

900

800

Figure 11

Europäisches
Patentamt

European
Patent Office

Office européen
des brevets

## EUROPEAN SEARCH REPORT

Application Number

EP 19 19 0753

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/154738 A1 (BOHNERT KLAUS [CH] ET AL) 23 May 2019 (2019-05-23) | 1,3-5,7, 8,11,12 | INV. G01R15/24 |
| A | * paragraph [0062] - paragraph [0072]; figure 3 * | 2,6,9, 10,13-15 | |
| X | EP 3 084 450 A1 (ABB TECHNOLOGY AG [CH]) 26 October 2016 (2016-10-26) * paragraphs [0004], [0005], [0012], [0026] - [0041], [0105]; claim 15; figure 1 * | 1,13 | |
| X | US 2009/039866 A1 (BOHNERT KLAUS [CH] ET AL) 12 February 2009 (2009-02-12) * paragraph [0013] - paragraph [0023]; figure 1 * | 1 | |
| A | US 2012/121216 A1 (OH MIN-CHEOL [KR]) 17 May 2012 (2012-05-17) * paragraph [0059]; figure 6 * | 1-15 | |

TECHNICAL FIELDS
SEARCHED (IPC)

G01R

The present search report has been drawn up for all claims

| Place of search | Date of completion of the search | Examiner |
|---|---|---|
| Berlin | 8 January 2020 | Andreassen, Jon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 19 0753

This annex lists the patent family members relating to the patent documents cited in the above-mentioned European search report.
The members are as contained in the European Patent Office EDP file on
The European Patent Office is in no way liable for these particulars which are merely given for the purpose of information.

08-01-2020

| Patent document cited in search report | | Publication date | Patent family member(s) | | Publication date |
|---|---|---|---|---|---|
| US 2019154738 | A1 | 23-05-2019 | AU | 2016415342 A1 | 14-03-2019 |
| | | | CN | 109477860 A | 15-03-2019 |
| | | | EP | 3488251 A1 | 29-05-2019 |
| | | | US | 2019154738 A1 | 23-05-2019 |
| | | | WO | 2018014975 A1 | 25-01-2018 |
| EP 3084450 | A1 | 26-10-2016 | AU | 2013407826 A1 | 21-07-2016 |
| | | | CN | 106030317 A | 12-10-2016 |
| | | | DK | 3084450 T3 | 15-01-2018 |
| | | | EP | 3084450 A1 | 26-10-2016 |
| | | | ES | 2654679 T3 | 14-02-2018 |
| | | | KR | 20160102023 A | 26-08-2016 |
| | | | US | 2016305984 A1 | 20-10-2016 |
| | | | WO | 2015090448 A1 | 25-06-2015 |
| US 2009039866 | A1 | 12-02-2009 | CN | 101427142 A | 06-05-2009 |
| | | | EP | 2010925 A1 | 07-01-2009 |
| | | | ES | 2681269 T3 | 12-09-2018 |
| | | | US | 2009039866 A1 | 12-02-2009 |
| | | | WO | 2007121592 A1 | 01-11-2007 |
| US 2012121216 | A1 | 17-05-2012 | CN | 102449491 A | 09-05-2012 |
| | | | US | 2012121216 A1 | 17-05-2012 |
| | | | WO | 2010137752 A1 | 02-12-2010 |

EPO FORM P0459

For more details about this annex : see Official Journal of the European Patent Office, No. 12/82